# EUROPÄISCHE PATENTSCHRIFT

(11) **EP 1 522 092 B1**
(45) Veröffentlichungstag und Bekanntmachung des Hinweises auf die Patenterteilung: **31.08.2011**
(21) Anmeldenummer: 03764890.4
(22) Anmeldetag: 11.07.2003
(51) Int. Cl.: H01L 21/20, H01L 21/02, H01L 21/762, H01L 21/314, H01L 29/10, H01L 29/786

(54) **HALBLEITERBAUELEMENT MIT STRESSAUFNEHMENDER HALBLEITERSCHICHT SOWIE ZUGEHÖRIGES HERSTELLUNGSVERFAHREN**
SEMICONDUCTOR ELEMENT WITH STRESS-CARRYING SEMICONDUCTOR LAYER AND CORRESPONDING PRODUCTION METHOD
COMPOSANT A SEMICONDUCTEUR POURVU D'UNE COUCHE SEMICONDUCTRICE ABSORBANT LES CONTRAINTES ET PROCEDE DE FABRICATION CORRESPONDANT

(30) Priorität: 15.07.2002 DE 10231964
(43) Veröffentlichungstag der Anmeldung: 13.04.2005
(73) Patentinhaber: Infineon Technologies AG, 85579 Neubiberg (DE)
(72) Erfinder: TEMPEL, Georg, B-1933 Sterrebeek (BE)
(74) Vertreter: Kindermann, Peter
(86) Internationale Anmeldenummer: PCT/DE2003/002352
(87) Internationale Veröffentlichungsnummer: WO 2004/010485

(56) Entgegenhaltungen:
- EP-A- 1 120 818
- US-A- 5 569 538
- US-A- 5 810 924
- PATENT ABSTRACTS OF JAPAN vol. 1999, no. 13, 30. November 1999 (1999-11-30) & JP 11 233440 A (TOSHIBA CORP), 27. August 1999 (1999-08-27)
- TEZUKA T ET AL: "HIGH-PERFORMANCE STRAINED SI-ON-INSULATOR MOSFETS BY NOVEL FABRICATION PROCESSES UTILIZING GE-CONDENSATION TECHNIQUE" 2002 SYMPOSIUM ON VLSI TECHNOLOGY. DIGEST OF TECHNICAL PAPERS. HONOLULU, JUNE 11 - 13, 2002, SYMPOSIUM ON VLSI TECHNOLOGY, NEW YORK, NY: IEEE, US, 11. Juni 2002 (2002-06-11), Seiten 96-97, XP001109835 ISBN: 0-7803-7312-X
- TEZUKA T ET AL: "Fabrication of a strained is on sub-10-nm-thick SiGe-on-insulator virtual substrate" MATERIALS SCIENCE AND ENGINEERING B, ELSEVIER SEQUOIA, LAUSANNE, CH, Bd. 89, Nr. 1-3, 14. Februar 2002 (2002-02-14), Seiten 360-363, XP004334431 ISSN: 0921-5107
- ZOGG H: "STRAIN RELIEF IN EPITAXIAL FLUORIDE BUFFER LAYERS FOR SEMICONDUCTORHETEROEPITAXY" APPLIED PHYSICS LETTERS, AMERICAN INSTITUTE OF PHYSICS. NEW YORK, US, Bd. 49, Nr. 15, 13. Oktober 1986 (1986-10-13), Seiten 933-935, XP000816962 ISSN: 0003-6951
- TEZUKA T ET AL: "Novel fully-depleted SiGe-on-insulator pMOSFETs with high-mobility SiGe surface channels", INTERNATIONAL ELECTRON DEVICES MEETING 2001. IEDM. TECHNICAL DIGEST. WASHINGTON, DC, DEC. 2 - 5, 2001; [INTERNATIONAL ELECTRON DEVICES MEETING], NEW YORK, NY : IEEE, US, 2 December 2001 (2001-12-02), pages 33.6_1-33.6_3, XP010575278, ISBN: 978-0-7803-7050-0

## Beschreibung

Die vorliegende Erfindung bezieht sich auf ein Halbleiterbauelement mit stressaufnehmender Halbleiterschicht sowie ein zugehöriges Herstellungsverfahren und insbesondere auf einen Sub-100 Nanometer-Feldeffekttransistor mit vollständig verarmten (fully depleted) aktivem Gebiet.

Mit der fortschreitenden Entwicklung von Halbleiterbauelementen werden zur Verbesserung einer Integrationsdichte immer kleiner werdende Strukturgrößen angestrebt. Hierbei stößt man jedoch auch auf Grund einer begrenzten Ladungsträgerbeweglichkeit in Halbleitermaterialien an bestimmte Grenzen. Da eine obere Grenze der Ladungsträgerbeweglichkeit von Elektronen und Löchern in einem Halbleiterkristall von den physikalischen Eigenschaften des Halbleiterkristalls abhängt, können bei sehr kleinen Strukturgrößen eines Halbleiterbauelements die benötigten Ladungsträgerbeweglichkeiten nicht oder nicht ausreichend genau eingestellt werden. Darüber hinaus verursachen auch für die steigende Integrationsdichte notwendige sogenannte high-k-Gatedielektrika (Dielektrika mit hoher Dielektrizitätskonstante) eine verringerte Ladungsträgerbeweglichkeit.

Es wurden daher sogenannte Halbleiterbauelemente mit stressaufnehmenden Halbleiterschichten (strained semiconductor) entwickelt, wodurch eine Ladungsträgerbeweglichkeit in einem stressaufnehmenden Halbleiterkristall verbessert werden kann.

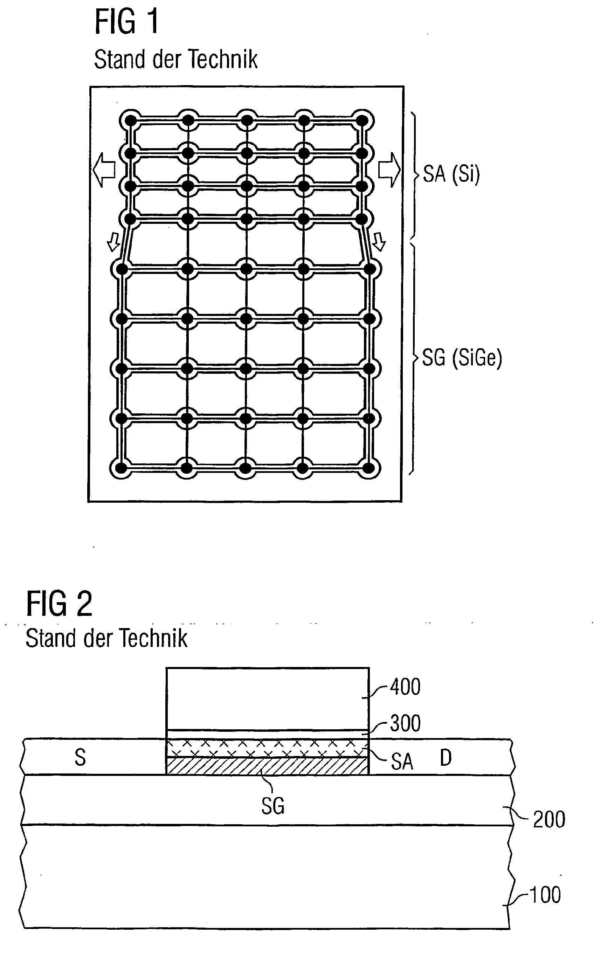

Figur 1 zeigt eine vereinfachte Kristalldarstellung zur Veranschaulichung dieses Effektes. Üblicherweise wird als stressaufnehmende Halbleiterschicht SA eine stressaufnehmende bzw. mechanisch beanspruchte Si-Schicht durch Aufwachsen einer dünnen Kristallschicht auf einem Trägerkristall ausgebildet, dessen Gitterkonstante verschieden zur Gitterkonstante des aufgewachsenen Siliziumkristalls ist. Üblicherweise verwendet man eine SiGe-Kristallschicht als sogenannte Stressgeneratorschicht SG, wobei der Ge-Gehalt einstellbar und vorzugsweise bei ca. 20% liegt. Auf diese Weise erhält man eine Gitterkonstante für den SiGe-Kristall SG, der um ca. 0,8% größer ist als die Gitterkonstante der darauf abgeschiedenen Si-Schicht SA. Aus diesen unterschiedlichen Gitterkonstanten ergeben sich insbesondere für die stressaufnehmende Si-Schicht SA die durch die Pfeile dargestellten mechanischen Beanspruchungen, wodurch sich letztendlich eine verbesserte Ladungsträgerbeweglichkeit aufgrund des sogenannten Piezoresistance-Effekt in dieser Schicht einstellen lässt.

Zur Realisierung von verbesserten Isolationseigenschaften und damit verringerten Leckströmen sowie verringerten Kapazitäten in einer Halbleiterschaltung werden üblicherweise sogenannte SOI-Substrate (Silicon On Insulator) verwendet, wobei sich jedoch eine Anwendung der vorstehend beschriebenen Technologie auf derartige SOI-Substrate nicht unmittelbar durchführen lässt.

Figur 2 zeigt eine vereinfachte Schnittansicht eines SiGe-on-Insulator-nMOSFETs, wie er beispielsweise aus der Literaturstelle T. Tezuka et al.: "Novel Fully-Depleted SiGe-On-Insulator pMOSFETs with High-Mobility SiGe Surface Channels" IEEE 2001 bekannt ist. Hierbei wird auf einem Si-Trägersubstrat 100 eine amorphe SiO₂-Schicht 200 ausgebildet, wodurch man ein typisches SOI-Substrat erhält. An der Oberfläche der SiO₂-Schicht 200 wird anschließend eine Stressgeneratorschicht SG ausgebildet, die in ihrem unteren Bereich eine kristalline Si-Schicht mit einer nachfolgend aufgewachsenen SiGe-Schicht zur Erzeugung der mechanischen Beanspruchung aufweist. Anschließend wird eine Si-Schicht als stressaufnehmende Halbleiterschicht SA aufgewachsen, die auf Grund der unterschiedlichen Gitterkonstanten unter einer mechanischen Beanspruchung steht und somit eine erhöhte Ladungsträgerbeweglichkeit aufweist. Abschließend wird eine Gateoxidschicht 300 und eine Poly-Siliziumschicht 400 als Steuerschicht ausgebildet, wobei zum Anschließen der ein Kanalgebiet K darstellenden stressaufnehmenden Halbleiterschicht SA Source- und Draingebiete S und D ausgebildet sind. Sowohl eine weitergehende Verringerung der Strukturgrößen insbesondere in einem sub-100nm-Bereich als auch eine weitere Verbesserung der elektrischen Eigenschaften lassen sich jedoch mit einem derartigen herkömmlichen Halbleiterbauelement mit stressaufnehmender Halbleiterschicht SA nicht realisieren.

Der Erfindung liegt daher die Aufgabe zu Grunde ein Halbleiterbauelement mit stressaufnehmender Halbleiterschicht sowie ein zugehöriges Herstellungsverfahren zu schaffen, welches auch in einem sub-100nm-Bereich verbesserte elektrische Eigenschaften aufweist.

Erfindungsgemäß wird diese Aufgabe hinsichtlich des Halbleiterbauelements durch die Merkmale des Patentanspruchs 1 und hinsichtlich des Herstellungsverfahrens durch die Maßnahmen des Patentanspruchs 9 gelöst.

Insbesondere durch die Verwendung einer auf einem Trägermaterial ausgebildeten kristallinen Stressgeneratorschicht und einer darauf ausgebildeten isolierenden Stressübertragungsschicht können in einer darauf ausgebildeten stressaufnehmenden Halbleiterschicht die erzeugten und übertragenen Beanspruchungen soweit aufgenommen werden, dass sich einerseits eine verbesserte Ladungsträgerbeweglichkeit einstellt und andererseits verbesserte elektrische Eigenschaften im Halbleiterbauelement realisiert werden können.

Vorzugsweise weist die stressaufnehmende Halbleiterschicht einen intrinsischen Halbleiter auf, wobei seine Dicke kleiner 1/3 einer Länge des Kanalgebiets ist, wodurch man ein Halbleiterbauelement mit vollständig verarmtem (fully depleted) Halbleiterkörper erhält. Neben der verbesserten Ladungsträgerbeweglichkeit erhält man dadurch mit einem einfachen Aufbau ferner einen verringerten Abschaltstrom (off-current).

Vorzugsweise weist die Stressübertragungsschicht eine zur zweiten Gitterkonstante der stressaufnehmenden Halbleiterschicht angepasste Gitterkonstante auf, wodurch man hervorragende Übertragungseigenschaften für die mechanische Beanspruchung bzw. den mechanischen Stress erhält.

Ferner können auf diese Weise erstmals in Halbleiterbauelementen mit stressaufnehmenden Schichten Gate-Dielektrika mit einer hohen Dielektrizitätskonstante und Steuerschichten mit einem Metallgate eingesetzt werden, wodurch sich eine äquivalente Oxiddicke (EOT, Equivalent Oxide Thickness) für das Gate-Dielektrikum verringert und hervorragende Gate-Ansteuereigenschaften realisiert werden können.

Zur Realisierung einer hervorragenden Ausgangsoberfläche wird als Trägermaterial vorzugsweise ein Si-Substrat mit einer (100)-Oberflächenorientierung und einer darauf abgeschiedenen Si-Pufferschicht verwendet.

Ferner kann zur Verbesserung einer Oberflächenqualität auch die Stressgeneratorschicht mittels eines molekularstrahlepitaktischen Verfahrens geglättet werden, wodurch man weiter verbesserte elektrische Eigenschaften für das Halbleiterbauelement erhält.

Vorzugsweise wird als Trägermaterial Si, als Stressgeneratorschicht SiGe, als Stressübertragungsschicht CaF₂, als stressaufnehmende Halbleiterschicht Si, als Gate-Dielektrikum HfO₂ und als Steuerschicht TiN verwendet, wodurch man unter Verwendung von Standardmaterialien einen besonders einfachen Aufbau und hervorragende Eigenschaften insbesondere bezüglich des Abschaltstroms, der Ladungsträgerbeweglichkeit, der äquivalenten Oxiddicke usw. erhält.

In den Unteransprüchen sind weitere vorteilhafte Ausgestaltungen der Erfindung gekennzeichnet.

Die Erfindung wird nachstehend anhand eines Ausführungsbeispiels unter Bezugnahme auf die Zeichnung näher beschrieben.

Es zeigen:
Figur 1 eine vereinfachte Kristalldarstellung zur Veranschaulichung wesentlicher Effekte in stressaufnehmenden Halbleiterschichten;
Figur 2 eine vereinfachte Schnittansicht eines herkömmlichen Halbleiterbauelements mit stressaufnehmender Halbleiterschicht; und
Figuren 3A und 3B vereinfachte Schnittansichten zur Veranschaulichung wesentlicher Verfahrensschritte bei der Herstellung eines erfindungsgemäßen Halbleiterbauelements mit stressaufnehmender Halbleiterschicht.

Die Erfindung wird nachfolgend anhand eines nMOSFETs als Halbleiterbauelement mit stressaufnehmender Halbleiterschicht beispielhaft beschrieben. Sie ist jedoch nicht darauf beschränkt und umfasst in gleicher Weise pMOSFETs sowie entsprechende andere Halbleiterbauelemente, die zur Verbesserung einer Ladungsträgerbeweglichkeit eine stressaufnehmende Halbleiterschicht aufweisen.

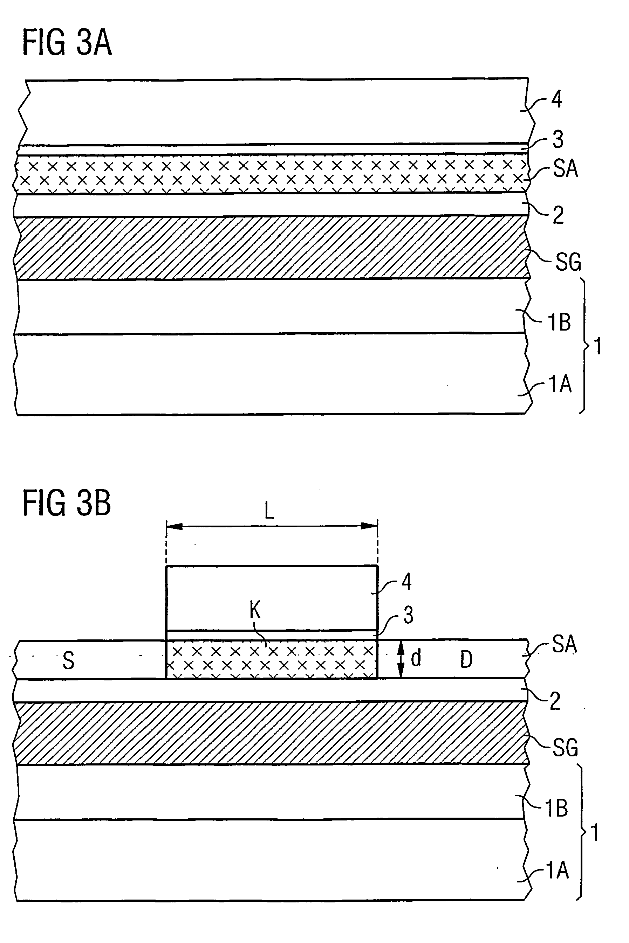

Gemäß Figur 3A wird zunächst ein Trägermaterial 1 bereitgestellt, welches beispielsweise ein Silizium-Halbleitermaterial aufweist. Alternativ können jedoch auch jedes andere kristalline und näherungsweise gitterangepasste Trägermaterial (z.B. Saphir usw.) verwendet werden.

Insbesondere zur Verbesserung einer Oberflächenqualität kann das Trägermaterial 1 beispielsweise aus einem Halbleitersubstrat 1A mit einer (100)-Oberflächenorientierung bestehen, wobei vorzugsweise ein Si-Substrat verwendet wird. Zur Realisierung einer hochwertigen Ausgangsoberfläche und um die Grenzflächenzustände an der Grenzfläche zwischen 1B und 1A zu vergraben kann gemäß Figur 3A beispielsweise eine Halbleiter-Pufferschicht 1B epitaktisch abgeschieden werden, wobei vorzugsweise eine Silizium-Pufferschicht mittels eines molekularstrahlepitaktischen Verfahrens (MBE) oder MOCVD-Verfahrens (Metal Organic Chemical Vapor Deposition) abgeschieden wird. Insbesondere bei Verwendung eines MBE-Verfahrens erhält man nach diesem Bearbeitungsschritt eine in einem Bereich von einer Atomlage geglättete Ausgangsoberfläche. Die Dicke der Pufferschicht 1B wird hierbei lediglich von einer Verarbeitungsgeschwindigkeit (Throughput) und einer vorgegebenen Ausgangsqualität bestimmt.

Alternativ können zu dem vorstehend beschriebenen Glättungsverfahren auch herkömmliche Glättungsverfahren wie z.B. CMP-Verfahren (Chemical Mechanical Polishing) durchgeführt werden.

Anschließend wird eine kristalline Stressgeneratorschicht SG auf dem Trägermaterial 1 bzw. der geglätteten Ausgangsoberfläche der Halbleiter-Bufferschicht 1B ausgebildet, wobei die Kristallstruktur dieser Stressgeneratorschicht SG im Wesentlichen eine erste Gitterkonstante zum Erzeugen einer mechanischen Beanspruchung in der später ausgebildeten stressaufnehmenden Halbleiterschicht aufweist.

Die Stressgeneratorschicht SG weist beispielsweise einen IV-IV- oder einen III-V-Halbleiter auf. Sie kann jedoch auch eine Mehrfachschichtenfolge aufweisen und/oder mittels eines molekularstrahlepitaktischen Verfahrens graduell sich ändern, wodurch man wiederum verbesserte Aufwachseigenschaften für die nachfolgenden Schichten erhält. Insbesondere bei Verwendung einer Si-Schicht als stressaufnehmende Halbleiterschicht SA wird für die Stressgeneratorschicht SG vorzugsweise Si₁₋ₓGeₓ als Halbleitermaterial verwendet, wobei ein Ge-Anteil von üblicherweise von 10 bis 50% (x = 0,1-0,5) eingestellt wird. Auf diese Weise erhält man eine zum Trägermaterial und insbesondere zur später auszubildenden stressaufnehmenden Halbleiterschicht SA leicht verschiedene Gitterkonstante in der Stressgeneratorschicht SG, die an ihrer (letzten) Atomschicht auf Grund seiner Fehlanpassung beispielsweise um einige Prozent (kleiner 10%) abweicht.

Bei der Realisierung eines sub-100 Nanometer-Halbleiterbauelements wird diese Stressgeneratorschicht SG mit einer typischen Dicke von 10 bis 300 Nanometer vorzugsweise mit einem MOCVD-Verfahren (Metal Organic Chemical Vapor Deposition) ausgebildet. Jede nachfolgend ausgebildete Kristallschicht mit einer deutlich kleineren Dicke wird demzufolge ihre Gitterkonstante relativ zu dieser obersten Schicht ausrichten.

Während in herkömmlichen Verfahren an dieser Stelle unmittelbar auf der Stressgeneratorschicht SG die stressaufnehmende Schicht SA ausgebildet wird, erfolgt beim erfindungsgemäßen Verfahren nunmehr die Ausbildung einer die erzeugte mechanische Beanspruchung übertragenden Stressübertragungsschicht 2, welche darüber hinaus isolierende Eigenschaften aufweist.

Da thermisch ausgebildete oder abgeschiedene Isolatorschichten wie z.B. Oxidschichten eine amorphe Struktur aufweisen, sind sie als Stressübertragungsschichten grundsätzlich nicht geeignet. Demgegenüber können kristalline Isolatorschichten mit einer vorbestimmten Kristallstruktur derartige in der Stressgeneratorschicht SG erzeugte mechanische Spannungen an eine nachfolgende stressaufnehmende Halbleiterschicht SA weiterleiten. Als derartige kristalline Isolatorschichten sind beispielsweise CdF2, CaF₂ und dergleichen bekannt.

Bei Verwendung einer aus Silizium bestehenden stressaufnehmenden Halbleiterschicht zeigt insbesondere CaF₂ besonders gute Eigenschaften, da die Gitterkonstante von CaF₂ sehr gut an die Gitterkonstante von Silizium angepasst (beispielsweise sehr ähnlich ist (Gitterkonstante CaF₂ = 0,546 Nanometer, Gitterkonstante von Si = 0,543 Nanometer bei Zimmertemperatur). Darüber hinaus stellt CaF₂ einen elektrischen Isolator dar mit dem größten Bandabstand (Valenzband zu Leitungsband = 12eV) aller existierenden Materialien. Auf Grund dieses außergewöhnlich großen Bandabstands (12 eV) ist es bei Verwendung von CaF₂ ausreichend, lediglich wenige Atomlagen an der Oberfläche der Stressgeneratorschicht SG auszubilden. Vorzugsweise wird demzufolge eine ca. 1 bis 2 Nanometer dicke CaF₂-Stressübertragungsschicht 2 als vergrabener Isolator mittels beispielsweise eines Atomlagen-Abscheideverfahrens (ALCVD, Atomic Layer Chemical Vapor Deposition) oder eines MBE-Verfahrens abgeschieden.

Nachfolgend erfolgt das Ausbilden der eigentlichen stressaufnehmenden Halbleiterschicht SA an der Oberfläche der isolierenden Stressübertragungsschicht 2, wobei vorzugsweise eine Silizium-Halbleiterschicht als aktives Gebiet, z.B. Kanalgebiet K, für das Halbleiterbauelement ausgebildet wird. Insbesondere bei der Realisierung von Sub-100 Nanometer-Halbleiterbauelementen, wobei Feldeffekttransistoren beispielsweise eine Kanallänge von 15 Nanometer aufweisen können, wird hierbei ein intrinsisches Halbleitermaterial, d.h. intrinsisches Silizium, mit einer Dicke d kleiner 1/3 einer Kanallänge L abgeschieden. Bei einer Kanallänge L = 15 Nanometer werden demzufolge mit ALCVD- oder MOCVD- oder MBE-Verfahren ca. d = 5 Nanometer intrinsisches Halbleitermaterial abgeschieden, wodurch man ein Halbleiterbauelement mit vollständig verarmtem aktiven Gebiet bzw. Halbleiterkörper erhält (fully depleted bodys).

Die isolierende Stressübertragungsschicht 2 gewährleistet hierbei die zuverlässige und vollständige Verarmung dieser gestressten bzw. stressaufnehmenden Halbleiterschicht SA, weshalb man neben der verbesserten Ladungsträgerbeweglichkeit auch alle Vorteile eines vollständig verarmten Halbleiterbauelements erhält. Da die Stressübertragungsschicht 2 ferner nur wenige Atomlagen aufweist und darüber hinaus im Falle von CaF₂ und Si hinsichtlich ihrer Gitterkonstanten optimal angepasst ist, wird die in der Stressgeneratorschicht SG erzeugte mechanische Beanspruchung bzw. Spannung nahezu verlustfrei an die stressaufnehmende Halbleiterschicht SA weitergegeben.

Anschließend wird gemäß Figur 3A an der Oberfläche der stressaufnehmenden Halbleiterschicht SA ein Gate-Dielektrikum 3 und eine Steuerschicht 4 ausgebildet. Das Gate-Dielektrikum 3 kann beispielsweise aus herkömmlichen Gate-Dielektrika wie z.B. Siliziumnitrid, Siliziumdioxid, ONO-Schichtenfolgen oder zukünftigen neuen high-k-Dielektrikas usw. bestehen, während die Steuerschicht 4 in gleicher Weise aus herkömmlichen Gatematerialien wie z.B. dotiertem Polysilizium oder Metall bestehen kann.

Vorzugsweise werden jedoch Gate-Dielektrika mit hoher dielektrischer Konstante bzw. sogenannte High-k-Dielektrika als Gate-Dielektrikum verwendet, wobei vorzugsweise HfO₂, HfSiₓO_{y}, HfSiNO usw. wiederum mittels eines ALCVD- oder MOCVD-Verfahrens in einer Dicke von typischen 3 Nanometer abgeschieden wird. Auf Grund der dramatischen Fehlanpassung der Gitterkonstanten dieser Materialien, d.h. des Gate-Dielektrikums, und wegen der niedrigen Abscheidetemperaturen zur stressaufnehmenden Halbleiterschicht SA, erfolgt der Abscheideprozess amorph.

Hinsichtlich des Gatematerials bzw. der Steuerschicht 4 wird - insbesondere bei angestrebter vollständiger Verarmung des aktiven Halbleiterkörpers - als Gatematerial ein sogenanntes Mid-Gap-Material abgeschieden. Derartige Materialien können Wechselwirkungen zu den High-k-Materialien des Gate-Dielektrikums 3 günstig beeinflussen, wobei im Falle der vorstehend genannten Hafnium-Gatematerialien vorzugsweise ein Metallgate wie z.B. TiN als Steuerschicht 4 verwendet wird.

Abschließend wird gemäß Figur 3B sowohl die Steuerschicht 4 als auch das Gate-Dielektrikum 3 strukturiert und in der stressaufnehmenden Halbleiterschicht SA jeweilige Source- und Draingebiete S und D zur Fertigstellung eines Feldeffekttransistors ausgebildet. Die weiteren Schritte zur Ausbildung von Spacern, Kontaktlöchern, Anschlussgebieten usw. entsprechen dem Stand der Technik, weshalb auf eine Beschreibung nachfolgend verzichtet wird.

Auf diese Weise können insbesondere Halbleiterbauelemente mit gestressten bzw. stressaufnehmenden und/oder unter vollständiger Verarmung arbeitende Halbleiterschichten auf einfache und kostengünstige Art und Weise hergestellt werden, wodurch insbesondere ein Abschaltstrom (off-current) verringert ist und eine Ladungsträgerbeweglichkeit und damit Taktrate des Halbleiterbauelements verbessert ist.

In gleicher Weise können insbesondere bei Verwendung von Gate-Dielektrika mit hoher dielektrischer Konstante die äquivalenten Oxiddicken (EOT, Equivalent Oxide Thickness) verringert werden, wodurch sich die Ansteuerung verbessert und insbesondere verringerte Spannungen realisiert werden können.

Die isolierende Stressübertragungsschicht verringert darüber hinaus sogenannte Punch-Through-Effekte und kann insbesondere einen Abschalt-Leckstrom (Off-State Leakage Current) beträchtlich verringern. Insbesondere steht jedoch nunmehr auch für Sub-100 Nanometer-Halbleiterbauelemente ein entsprechender Schichtaufbau zur Verfügung, mit dem Halbleiterbauelemente mit geringen Abweichungen der elektrischen Eigenschaften und ausreichender Reproduzierbarkeit gefertigt werden können.

Die Erfindung wurde vorstehend anhand eines nMOSFETs beschrieben. Sie ist jedoch nicht darauf beschränkt und umfasst in gleicher Weise pMOSFETs oder sonstige Halbleiterbauelemente mit stressaufnehmender Halbleiterschicht. Ferner wurde die Erfindung anhand einer aus Silizium bestehenden stressaufnehmenden Halbleiterschicht und einer aus CaF₂ bestehenden Stressübertragungsschicht beschrieben. Es können in gleicher Weise jedoch auch alternative Materialien zur Realisierung dieser Schichten verwendet werden.

## Patentansprüche

1. Halbleiterbauelement mit verspannter Halbleiterschicht mit:
einem Trägermaterial (1) mit einer ersten Gitterkonstante;
einer auf dem Trägermaterial (1) ausgebildeten kristallinen ersten Schicht (SG), welche in ihrer letzten Atomschicht eine zur ersten Gitterkonstante verschiedene zweite Gitterkonstante zum Erzeugen einer mechanischen Beanspruchung aufweist;
einer auf der ersten Schicht (SG) ausgebildeten isolierenden zweiten Schicht (2), welche eine zum Trägermaterial (1) angepasste dritte Gitterkonstante zum Übertragen der erzeugten mechanischen Beanspruchung aufweist;
einer auf der zweiten Schicht (2) ausgebildeten kristallinen, verspannten Halbleiterschicht (SA) mit einer zur zweiten Gitterkonstante verschiedenen Gitterkonstante zum Aufnehmen der übertragenen mechanischen Beanspruchung und zur Realisierung von Source/Draingebieten (S, D) sowie einem Kanalgebiet (K); einem zumindest an der Oberfläche des Kanalgebietes (K) ausgebildeten Gate-Dielektrikum (3); und
einer auf dem Gate-Dielektrikum (3) ausgebildeten Steuerschicht (4) zum Ansteuern des Kanalgebiets (K).

2. Halbleiterbauelement nach Patentanspruch 1,
**dadurch gekennzeichnet, dass** die verspannte Halbleiterschicht (SA) eine Dicke (d) kleiner 1/3 einer Länge (L) des Kanalgebietes (K) aufweist.

3. Halbleiterbauelement nach Patentanspruch 1 oder 2,
**dadurch gekennzeichnet, dass** die zweite Schicht (2) eine kristalline Isolatorschicht darstellt.

4. Halbleiterbauelement nach Patentanspruch 3,
**dadurch gekennzeichnet, dass** die zweite Schicht (2) eine zur Gitterkonstante der verspannten Halbleiterschicht (SA) angepasste Gitterkonstante aufweist.

5. Halbleiterbauelement nach einem der Patentansprüche 1 bis 4,
**dadurch gekennzeichnet, dass** die erste Schicht (SG) eine 10 bis 300 nm dicke SiGe-Schicht,
die zweite Schicht (2) eine 1 bis 2 nm dicke CaF₂-Schicht und
die verspannte Halbleiterschicht (SA) eine 5 nm dicke Si-Schicht darstellt.

6. Halbleiterbauelement nach einem der Patentansprüche 1 bis 5,
**dadurch gekennzeichnet, dass** das Gate-Dielektrikum (3) eine hohe Dielektrizitätskonstante aufweist.

7. Halbleiterbauelement nach einem der Patentansprüche 1 bis 6,
**dadurch gekennzeichnet, dass** die Steuerschicht (4) ein Metall aufweist.

8. Halbleiterbauelement nach einem der Patentansprüche 1 bis 7,
**dadurch gekennzeichnet, dass** das Trägermaterial (1)
ein Si-Substrat (1A) mit einer (100)-Oberflächenorientierung und
eine Si-Pufferschicht (1B) zum Erzeugen einer glatten Ausgangsoberfläche für die erste Schicht (SG) aufweist.

9. Verfahren zur Herstellung eines Halbleiterbauelements mit verspannter Halbleiterschicht mit den Schritten:
a) Ausbilden eines Trägermaterials (1) mit einer ersten Gitterkonstante;
b) Ausbilden einer kristallinen ersten Schicht (SG), welche in ihrer letzten Atomschicht eine zur ersten Gitterkonstante verschiedene zweite Gitterkonstante aufweist, auf dem Trägermaterial (1) zum Erzeugen einer mechanischen Beanspruchung;
c) Ausbilden einer isolierenden zweiten Schicht (2) auf der ersten Schicht (SG) zum Übertagen der erzeugten mechanischen Beanspruchung, welche eine zum Trägermaterial (1) angepasste dritte Gitterkonstante aufweist;
d) Ausbilden einer kristallinen, verspannten Halbleiterschicht (SA) mit einer zur zweiten Gitterkonstante verschiedenen Gitterkonstante auf der zweiten Schicht (2) zum Aufnehmen der mechanischen Beanspruchung;
e) Ausbilden eines Gate-Dielektrikums (3) auf der verspannten Halbleiterschicht (SA);
f) Ausbilden einer Steuerschicht (4) auf dem Gate-Dielektrikum (3);
g) Strukturieren des Gate-Dielektrikums (3) und der Steuerschicht (4); und
h) Ausbilden von Source-/Draingebieten (S, D) in der verspannten Halbleiterschicht (SA).

10. Verfahren nach Patentanspruch 9,
**dadurch gekennzeichnet, dass** in Schritt a) ein Halbleitersubstrat (1A) mit einer (100)-Oberflächenorientierung bereitgestellt und zum Erzeugen einer glatten Oberfläche darauf eine Halbleiter-Pufferschicht (1B) epitaktisch abgeschieden wird.

11. Verfahren nach Patentanspruch 9 oder 10,
**dadurch gekennzeichnet, dass** in Schritt b) ein IV-IV- oder III-V-Halbleiter verwendet wird.

12. Verfahren nach Patentanspruch 11,
**dadurch gekennzeichnet, dass** in Schritt b) eine Mehrfach-Schichtenfolge als erste Schicht (SG) ausgebildet wird.

13. Verfahren nach einem der Patentansprüche 9 bis 12,
**dadurch gekennzeichnet, dass** in Schritt b) die erste Schicht (SG) mittels eines molekularstrahlepitaktischen Verfahrens geglättet wird.

14. Verfahren nach einem er Patentansprüche 9 bis 13,
**dadurch gekennzeichnet, dass** in Schritt c) die kristalline Isolatorschicht als zweite Schicht (2) ausgebildet wird.

15. Verfahren nach Patentanspruch 14,
**dadurch gekennzeichnet, dass** in Schritt c) die zweite Schicht (2) mit einer zur Gitterkonstante der verspannten Halbleiterschicht (SA) angepassten Gitterkonstante ausgebildet wird.

16. Verfahren nach Patentanspruch 15,
**dadurch gekennzeichnet, dass** in Schritt c) nur wenige Atomlagen der zweiten Schicht (2) auf der ersten Schicht (SG) epitaktisch abgeschieden werden.

17. Verfahren nach einem der Patentansprüche 9 bis 16,
**dadurch gekennzeichnet, dass** in Schritt d) ein vollständig verarmtes Halbleitermaterial verwendet wird.

18. Verfahren nach einem der Patentansprüche 9 bis 17,
**dadurch gekennzeichnet, dass** in Schritt e) als Gate-Dielektrikum (3) ein Material mit hoher dielektrischer Konstante verwendet wird.

19. Verfahren nach einem der Patentansprüche 9 bis 18,
**dadurch gekennzeichnet, dass** in Schritt f) als Steuerschicht (4) ein Metall verwendet wird.

20. Verfahren nach einem der Patentansprüche 9 bis 19,
**dadurch gekennzeichnet, dass** in Schritt a) Si als Trägermaterial (1);
in Schritt b) SiGe als erste Schicht (SG);
in Schritt c) CaF₂ als zweite Schicht (2);
in Schritt d) Si als verspannte Halbleiterschicht (SA);
in Schritt e) HfO₂ als Gate-Dielektrikum (3); und
in Schritt f) TiN als Steuerschicht (4) verwendet wird.

## Claims

1. Semiconductor component comprising a strained semiconductor layer, having:
a carrier material (1) with a first lattice constant;
a crystalline first layer (SG), which is formed on the carrier material (1) and in its last atomic layer has a second lattice constant, different from the first lattice constant, in order to produce a mechanical stress;
an insulating second layer (2), which is formed on the first layer (SG) and has a third lattice constant, matched to the carrier material (1), in order to transmit the mechanical stress produced;
a crystalline, strained semiconductor layer (SA) which is formed on the second layer (2) and has a lattice constant, which is different than the second lattice constant, for absorbing the mechanical stress which has been transmitted and for realizing source/drain regions (S, D) and a channel region (K);
a gate dielectric (3) which is formed at least at the surface of the channel region (K); and
a control layer (4) for driving the channel region (K), which is formed on the gate dielectric (3).

2. Semiconductor component according to Patent Claim 1, **characterized in that** the strained semiconductor layer (SA) has a thickness (d) less than 1/3 of a length (L) of the channel region (K).

3. Semiconductor component according to Patent Claim 1 or 2, **characterized in that** the second layer (2) forms a crystalline insulator layer.

4. Semiconductor component according to Patent Claim 3, **characterized in that** the second layer (2) has a lattice constant which is matched to the lattice constant of the strained semiconductor layer (SA).

5. Semiconductor component according to one of Patent Claims 1 to 4, **characterized in that** the first layer (SG) is a 10 to 300 nm thick SiGe layer, the second layer (2) is a 1 to 2 nm thick CaF₂ layer, and
the strained semiconductor layer (SA) is a 5 nm thick Si layer.

6. Semiconductor component according to one of Patent Claims 1 to 5, **characterized in that** the gate dielectric (3) has a high dielectric constant.

7. Semiconductor component according to one of Patent Claims 1 to 6, **characterized in that** the control layer (4) includes a metal.

8. Semiconductor component according to one of Patent Claims 1 to 7, **characterized in that** the carrier material (1) includes
an Si substrate (1A) with a (100) surface orientation, and
an Si buffer layer (1B) for generating a smooth starting surface for the first layer (SG).

9. Method for fabricating a semiconductor component with a strained semiconductor layer, comprising the steps of:
a) forming a carrier material (1) having a first lattice constant;
b) forming a crystalline first layer (SG) having, in its last atom layer, a second lattice constant, which is different than the first lattice constant, on the carrier material (1) in order to generate a mechanical stress;
c) forming an insulating second layer (2) on the first layer (SG) for transmitting the mechanical stress which has been generated, which second layer has a third lattice constant which is matched to the carrier material (1);
d) forming a crystalline, strained semiconductor layer (SA) having a lattice constant, which is different than the second lattice constant, on the second layer (2) for the purpose of absorbing the mechanical stress;
e) forming a gate dielectric (3) on the strained semiconductor layer (SA);
f) forming a control layer (4) on the gate dielectric (3);
g) patterning the gate dielectric (3) and the control layer (4); and
h) forming source/drain regions (S, D) in the strained semiconductor layer (SA).

10. Method according to Patent Claim 9, **characterized in that** in step a) a semiconductor substrate (1A) having a (100) surface orientation is provided, and a semiconductor buffer layer (1B) is epitaxially deposited thereon in order to produce a smooth surface.

11. Method according to Patent Claim 9 or 10, **characterized in that** in step b) a IV-IV or III-V semiconductor is used.

12. Method according to Patent Claim 11, **characterized in that** in step b) a multiple layer sequence is formed as first layer (SG).

13. Method according to one of Patent Claims 9 to 12, **characterized in that** in step b) the first layer (SG) is smoothed by means of a molecular beam epitaxy process.

14. Method according to one of Patent Claims 9 to 13, **characterized in that** in step c) the crystalline insulator layer is formed as second layer (2).

15. Method according to Patent Claim 14, **characterized in that** in step c) the second layer (2) with a lattice constant which is matched to the lattice constant of the strained semiconductor layer (SA) is formed.

16. Method according to Patent Claim 15, **characterized in that** in step c) only a few atom layers of the second layer (2) are deposited epitaxially on the first layer (SG).

17. Method according to one of Patent Claims 9 to 16, **characterized in that** in step d) a fully depleted semiconductor material is used.

18. Method according to one of Patent Claims 9 to 17, **characterized in that** in step e) a material with a high dielectric constant is used as gate dielectric (3).

19. Method according to one of Patent Claims 9 to 18, **characterized in that** in step f) a metal is used as control layer (4).

20. Method according to one of Patent Claims 9 to 19, **characterized in that**
in step a) Si is used as carrier material (1);
in step b) SiGe is used as first layer (SG);
in step c) CaF₂ is used as second layer (2);
in step d) Si is used as strained semiconductor layer (SA);
in step e) HfO₂ is used as gate dielectric (3); and
in step f) TiN is used as control layer (4).

## Revendications

1. Composant à semiconducteur ayant une couche semiconductrice bloquée, comprenant :
un matériau (1) de support ayant une première constante de réseau ;
une première couche (SG) cristalline, qui est formée sur le matériau (1) de support et qui a, dans sa dernière couche d'atome, une deuxième constante de réseau différente de la première constante de réseau pour la production d'une contrainte mécanique ;
une deuxième couche (2) isolante, qui est formée sur la première couche (SG) et qui a une troisième constante de réseau adaptée au matériau (1) de support pour la transmission de la contrainte mécanique produite ;
un couche (SA) semiconductrice cristalline bloquée formée sur la deuxième couche (2) et ayant une constante de réseau différente de la deuxième constante de réseau pour l'absorption de la contrainte mécanique transmise et pour la réalisation de zones (S, D) de source/drain ainsi que d'une zone (K) de canal ;
un diélectrique (3) de grille formé au moins à la surface de la zone (K) de canal ; et
une couche (4) de commande formée sur le diélectrique (3) de grille pour la commande de la zone (K) de canal.

2. Composant à semiconducteur suivant la revendication 1, **caractérisé en ce que** la couche (SA) semiconductrice bloquée a une épaisseur (d) plus petite que le tiers d'une longueur (L) de la zone (K) de canal.

3. Composant à semiconducteur suivant la revendication 1 ou 2, **caractérisé en ce que** la deuxième couche (2) constitue une couche cristalline isolante.

4. Composant à semiconducteur suivant la revendication 3, **caractérisé en ce que** la deuxième couche (2) a une constante de réseau adaptée à la constante de réseau de la couche (SA) semiconductrice bloquée.

5. Composant à semiconducteur suivant l'une des revendications 1 à 4,
**caractérisé en ce que** la première couche (SG) est une couche en SiGe d'une épaisseur de 10 à 300 nm,
la deuxième couche (2) une couche en CaF₂ d'une épaisseur de 1 à 2 nm et
la couche (SA) semiconductrice bloquée une couche en Si d'une épaisseur de 5 nm.

6. Composant à semiconducteur suivant l'une des revendications 1 à 5,
**caractérisé en ce que** le diélectrique (3) de grille a une grande constante diélectrique.

7. Composant à semiconducteur suivant l'une des revendications 1 à 6,
**caractérisé en ce que** la couche (4) de commande comporte un métal.

8. Composant à semiconducteur suivant l'une des revendications 1 à 7,
**caractérisé en ce que** le matériau (1) de support comprend un substrat (1A) en Si ayant une orientation de surface (100) et
une couche (1B) tampon en Si pour la production d'une surface de sortie lisse pour la première couche (SG).

9. Procédé de production d'un composant à semiconducteur ayant une couche semiconductrice bloquée, comprenant les stades, dans desquels :
a) on forme un matériau (1) de support ayant une première constante de réseau ;
b) on forme une première couche (SG) cristalline, qui a, dans sa dernière couche d'atome, une deuxième constante de réseau différente de la première constante de réseau sur le matériau (1) de support pour la production d'une contrainte mécanique ;
c) on forme une deuxième couche (2) isolante sur la première couche (SG) pour la transmission de la contrainte mécanique produite, qui a une troisième constante de réseau adaptée au matériau (1) de support ;
d) on forme une couche (SA) semiconductrice cristalline bloquée ayant une constante de réseau différente de la deuxième constante de réseau sur la deuxième couche (2) pour l'absorption de la contrainte mécanique ;
e) on forme un diélectrique (3) de grille sur la couche (SA) semiconductrice bloquée ;
f) on forme une couche (4) de commande sur le diélectrique (3) de grille ;
g) on structure le diélectrique (3) de grille et la couche (4) de commande ; et
h) on forme des zones (S, D) de source/drain dans la couche (SA) semiconductrice bloquée.

10. Procédé suivant la revendication 9,
**caractérisé en ce que**
au stade a), on se procure un substrat (1A) semiconducteur ayant une orientation de surface (100) et, pour la production d'une surface lisse, on y dépose par épitaxie une couche (1B) tampon semiconductrice.

11. Procédé suivant la revendication 9 ou 10,
**caractérisé en ce que**
au stade b), on utilise un semiconducteur IV-IV ou III-V.

12. Procédé suivant la revendication 11,
**caractérisé en ce que**
au stade d), on forme comme première couche (SG) une succession de couches multiples.

13. Procédé suivant l'une des revendications 9 à 12,
**caractérisé en ce que**
au stade b), on rend lisse la première couche (SG) au moyen d'un procédé d'épitaxie par faisceau moléculaire.

14. Procédé suivant l'une des revendications 9 à 13,
**caractérisé en ce que**
au stade c), on forme la couche cristalline isolante en tant que deuxième couche (2).

15. Procédé suivant la revendication 14,
**caractérisé en ce que**
au stade c), on forme la deuxième couche (2) avec une constante de réseau adaptée à la constante de réseau de la couche (SA) semiconductrice bloquée.

16. Procédé suivant la revendication 15,
**caractérisé en ce que**
au stade c), on ne dépose par épitaxie que quelques couches d'atome de la deuxième couche (2) sur la première couche (SG).

17. Procédé suivant l'une des revendications 9 à 16,
**caractérisé en ce que**
au stade d), on utilise un matériau semiconducteur appauvri complètement.

18. Procédé suivant l'une des revendications 9 à 17,
**caractérisé en ce que**
au stade e), on utilise comme diélectrique (3) de grille un matériau ayant une grande constante diélectrique.

19. Procédé suivant l'une des revendications 9 à 18,
**caractérisé en ce que**
au stade f), on utilise un métal comme couche (4) de commande.

20. Procédé suivant l'une des revendications 9 à 19,
**caractérisé en ce qu'**on utilise
au stade a), Si comme matériau (1) de support ;
au stade b), SiGe comme première couche (SG) ;
au stade c), CaF₂ comme deuxième couche (2) ;
au stade d), Si comme couche (SA) semiconductrice bloquée ;
au stade e), HfO₂ comme diélectrique (3) de grille ; et
au stade f), TiN comme couche (4) de commande.
